# EUROPEAN PATENT APPLICATION

(11) **EP 4 811 634 A1**
(43) Date of publication of application: **23.09.2026**
(21) Application number: 26163583.3
(22) Date of filing: 10.03.2026
(51) Int. Cl.: H02M 1/32, H02M 1/00, H02M 3/158, H02M 3/07

(54) **POWER CONVERTER, METHOD FOR DETERMINING CAPACITANCE VALUE OF FLYING CAPACITOR OF POWER CONVERTER, AND ENERGY STORAGE SYSTEM**

(30) Priority: 10.03.2025 CN 202510280444
(71) Applicant: HUAWEI TECHNOLOGIES CO., LTD., Shenzhen, Guangdong 518129 (CN)
(72) Inventor: XU, Fuqiang, 518129 Shenzhen, Guangdong (CN); LI, Hang, 518129 Shenzhen, Guangdong (CN); LI, Junjie, 518129 Shenzhen, Guangdong (CN); YU, Xinyu, 518129 Shenzhen, Guangdong (CN)
(74) Representative: Maiwald GmbH

(57) **Abstract**

This application provides a power converter, a method for determining a capacitance value of a flying capacitor of the power converter, and an energy storage system, and belongs to the field of power electronics technologies. The power converter provided in this application includes a controller and a direct current/direct current conversion circuit. In the direct current/direct current conversion circuit, a capacitance voltage of the flying capacitor has a voltage disturbance component of a target frequency, and a capacitance current flowing through the flying capacitor has a current disturbance component of the target frequency. Therefore, the controller can reliably calculate a capacitance value of the flying capacitor based on an effective value of the current disturbance component of the target frequency and an effective value of the voltage disturbance component of the target frequency, to implement real-time online detection of the capacitance value of the flying capacitor.

## Description

### TECHNICAL FIELD

This application relates to the field of power electronics technologies, and in particular, to a power converter, a method for determining a capacitance value of a flying capacitor of the power converter, and an energy storage system.

### BACKGROUND

A flying capacitor (flying capacitor, FC) is a capacitor used in a multi-level converter, is mainly configured to: store and transfer energy between different levels, and is commonly used in power electronic devices such as a power management system and a renewable energy system. The multi-level converter is, for example, a three-level boost (Boost) circuit in a direct current (direct current, DC)/DC converter.

A capacitance value of the flying capacitor is attenuated due to impact of a plurality of factors such as an operating environment (for example, a temperature and humidity), operating duration, and an operating condition of the device. If the capacitance value is attenuated to a specific extent, normal operation of the device is affected. Therefore, a solution for reliably determining a capacitance value of a flying capacitor is urgently needed.

### SUMMARY

A power converter, a method for determining a capacitance value of a flying capacitor of the power converter, and an energy storage system are provided, to resolve a technical problem in a related technology that the capacitance value of the flying capacitor cannot be reliably determined.

According to a first aspect, a power converter is provided. The power converter includes a controller and a direct current/direct current conversion circuit. The direct current/direct current conversion circuit includes an inductor, a flying capacitor, a first diode, a second diode, a first switching transistor, and a second switching transistor. The first diode, the second diode, the first switching transistor, and the second switching transistor are sequentially connected in series between a positive bus and a negative bus. One end of the inductor is configured to connect to an energy storage battery or a photovoltaic module, and the other end of the inductor is connected to a series connection node of the second diode and the first switching transistor. The flying capacitor is connected in parallel to the second diode and the first switching transistor that are connected in series. The controller is configured to: provide pulse-width modulation (pulse-width modulation, PWM) signals for the first switching transistor and the second switching transistor, to control a capacitance voltage of the flying capacitor to maintain at half of a bus voltage; and determine a capacitance value of the flying capacitor based on an effective value of a current disturbance component of a target frequency on the flying capacitor and an effective value of a voltage disturbance component of the target frequency on the flying capacitor. The capacitance value is positively correlated with the effective value of the current disturbance component of the target frequency, and the capacitance value is negatively correlated with the effective value of the voltage disturbance component of the target frequency.

In the direct current/direct current conversion circuit included in the power converter, the capacitance voltage of the flying capacitor has the voltage disturbance component of the target frequency, and a capacitance current flowing through the flying capacitor has the current disturbance component of the target frequency. The voltage disturbance component and the current disturbance component are generally sine alternating current components. On this basis, the controller included in the power converter can reliably calculate the capacitance value of the flying capacitor based on the effective value of the current disturbance component of the target frequency and the effective value of the voltage disturbance component of the target frequency, to implement real-time online detection of the capacitance value of the flying capacitor.

Optionally, the capacitance value C may satisfy: $C = \frac{1}{2 {πf}_{h}} ∗ \frac{{I}_{h , rms}}{{U}_{h , rms}}$, where *fₕ* is the target frequency, *U_{h,rms}* is the effective value of the voltage disturbance component of the target frequency, and *I_{h,rms}* is the effective value of the current disturbance component of the target frequency.

In the foregoing formula, a subscript h represents a high frequency (high frequency), and rms represents a root mean square (root mean square). That is, the controller can calculate the effective value based on the root mean square. For a sine alternating current component, an effective value is generally a root mean square of a peak value of the sine alternating current component. In this application, the controller can directly substitute the effective value of the current disturbance component of the target frequency and the effective value of the voltage disturbance component of the target frequency into the foregoing formula. In this way, the capacitance value of the flying capacitor can be quickly and reliably calculated.

Optionally, the controller may be configured to: determine the effective value of the current disturbance component of the target frequency based on an estimated current disturbance component; and determine the effective value of the voltage disturbance component of the target frequency based on the capacitance voltage. The estimated current disturbance component is positively correlated with both an inductance current flowing through the inductor and a duty cycle difference, and the duty cycle difference is a difference between a duty cycle of the PWM signal provided by the controller for the first switching transistor and a duty cycle of the PWM signal provided for the second switching transistor.

Because the inductance current flowing through the inductor is generally equal to the capacitance current flowing through the flying capacitor, in this application, the controller can first calculate the estimated current disturbance component based on the inductance current and the duty cycle difference, and then reliably determine the required effective value of the current disturbance component of the target frequency based on the estimated current disturbance component. In addition, the controller can directly determine the effective value of the required voltage disturbance component of the target frequency based on the capacitance voltage. Both the inductance current and the capacitance voltage may be obtained by the controller through a sampling circuit.

Optionally, the controller may be configured to perform band-pass filtering on the estimated current disturbance component to obtain a current component of the target frequency. A passband of the band-pass filtering includes the target frequency, and the effective value of the current disturbance component of the target frequency is an effective value of the current component of the target frequency.

It may be understood that band-pass filtering is a processing manner in which a signal of an included specific frequency is allowed to pass, and a signal of another frequency is attenuated. The passband of the band-pass filtering is a specific frequency that is allowed to pass. In addition, because the estimated current disturbance component calculated based on the inductance current and the duty cycle difference generally includes a plurality of frequency components, after determining the estimated current disturbance component, the controller may first reliably extract the current component of the target frequency from the estimated current disturbance component in the band-pass filtering manner including the target frequency. Then, the controller may further calculate the effective value of the current component of the target frequency. In addition, the calculated effective value of the current component of the target frequency is the effective value of the current disturbance component of the target frequency that is required for determining the capacitance value. For example, the controller may calculate a root mean square of the current component to obtain the effective value.

Optionally, the estimated current disturbance component I_{FR} may satisfy: I_{FR} = 2*I_{L}*D, where I_{L} is the inductance current, and D is the duty cycle difference.

In this application, on a basis of determining the inductance current and the duty cycle difference, the controller may substitute the inductance current and the duty cycle difference into the calculation formula of the estimated current disturbance component I_{FR}, to quickly and reliably obtain the estimated current disturbance component that is brought to the capacitance current. In addition, it may be understood that, when the controller controls the first switching transistor or the second switching transistor to be turned on, the inductance current flowing through the inductor is generally equal to the capacitance current flowing through the flying capacitor. In this way, D>0 is used as an example, that is, when the duty cycle of the PWM signal provided for the first switching transistor is greater than the duty cycle of the PWM signal provided for the second switching transistor, turn-on duration of the first switching transistor is increased, and turn-on duration of the second switching transistor is decreased. In this case, a current for charging the flying capacitor is equivalently increased by I_{L}*D, and a current for discharging the flying capacitor is equivalently decreased by I_{L}*D. In this way, it may be determined that in one switching period, an estimated current disturbance component generated in the capacitance current flowing through the flying capacitor is 2*I_{L}*D. D<0 is similar, but a current direction is opposite.

Optionally, the controller may be configured to perform band-pass filtering on the capacitance voltage to obtain a voltage component of the target frequency. A passband of the band-pass filtering includes the target frequency, and the effective value of the voltage disturbance component of the target frequency is an effective value of the voltage component of the target frequency.

Similarly, because the voltage disturbance component in the capacitance voltage generally includes a plurality of frequency components, after determining the capacitance voltage, the controller may first reliably extract the voltage component of the target frequency from the voltage disturbance component in the band-pass filtering manner including the target frequency. Then, the controller may further calculate the effective value of the voltage component of the target frequency. In addition, the calculated effective value of the voltage component of the target frequency is the effective value of the voltage disturbance component of the target frequency that is required for determining the capacitance value. In addition, the controller may also calculate a root mean square of the voltage component to obtain the effective value.

Optionally, the inductance current may be an average current value of inductance currents flowing through the inductor at at least two different moments in each switching period.

That is, the controller may determine the effective value of the current disturbance component of the target frequency based on the average current value of the inductance currents instead of an instantaneous current value of the inductance current. In addition, it may be understood that, compared with the instantaneous current value, the average current value can better reflect a change trend of the inductance currents. In this way, the controller can more accurately and reliably determine the effective value of the current disturbance component of the target frequency based on the average current value.

Optionally, the controller may be further configured to: if the capacitance value of the flying capacitor is less than a capacitance value threshold, perform at least one of the following operations: decreasing rated power of the direct current/direct current conversion circuit; controlling the direct current/direct current conversion circuit to stop operating; and sending an alarm signal. The capacitance value threshold may be less than or equal to a nominal capacitance value of the flying capacitor.

In this application, after detecting the capacitance value of the flying capacitor, the controller may further detect whether the capacitance value is greatly attenuated compared with the nominal capacitance value, and when detecting that the capacitance value is greatly attenuated, may further decrease the rated power of the direct current/direct current conversion circuit, control the direct current/direct current conversion circuit to stop operating, and/or send the alarm signal, that is, perform a derating operation and a protection operation. This can prevent the flying capacitor from affecting stable operation of the direct current/direct current converter due to an abnormality, and can implement timely and reliable protection for the direct current/direct current converter.

According to a second aspect, a method for determining a capacitance value of a flying capacitor of a power converter is provided. The power converter includes a controller and a direct current/direct current conversion circuit. The direct current/direct current conversion circuit includes a flying capacitor, an inductor, a first diode, a second diode, a first switching transistor, and a second switching transistor. The first diode, the second diode, the first switching transistor, and the second switching transistor are sequentially connected in series between a positive bus and a negative bus. One end of the inductor is configured to connect to an energy storage battery or a photovoltaic module, and the other end of the inductor is connected to a series connection node of the second diode and the first switching transistor. The flying capacitor is connected in parallel to the second diode and the first switching transistor that are connected in series. The method includes: providing pulse width modulation PWM signals for a first switching transistor and a second switching transistor, to control a capacitance voltage of the flying capacitor to maintain at half of a bus voltage; and determining a capacitance value of the flying capacitor based on an effective value of a current disturbance component of a target frequency on the flying capacitor and an effective value of a voltage disturbance component of the target frequency on the flying capacitor. The capacitance value is positively correlated with the effective value of the current disturbance component of the target frequency, and the capacitance value is negatively correlated with the effective value of the voltage disturbance component of the target frequency.

According to a third aspect, an energy storage system is provided. The energy storage system includes an energy storage battery and the power converter provided in the first aspect. The direct current/direct current conversion circuit of the power converter is connected to the energy storage battery, and is configured to perform voltage conversion on a direct current provided by the energy storage battery.

In conclusion, this application provides the power converter, the method for determining a capacitance value of a flying capacitor of the power converter, and an energy storage system. The power converter provided in this application includes the controller and the direct current/direct current conversion circuit. In the direct current/direct current conversion circuit, the capacitance voltage of the flying capacitor has the voltage disturbance component of the target frequency, and the capacitance current flowing through the flying capacitor has the current disturbance component of the target frequency. Therefore, the controller can reliably calculate the capacitance value of the flying capacitor based on the effective value of the current disturbance component of the target frequency and the effective value of the voltage disturbance component of the target frequency, to implement real-time online detection of the capacitance value of the flying capacitor.

### BRIEF DESCRIPTION OF DRAWINGS

FIG. 1 is a diagram of a structure of a photovoltaic energy storage system according to an embodiment of this application;
FIG. 2 is a diagram of a structure of a power converter according to an embodiment of this application;
FIG. 3 is a diagram of a signal waveform of a power converter according to an embodiment of this application;
FIG. 4 is a block diagram of a control loop of a power converter according to an embodiment of this application;
FIG. 5 is a block diagram of a manner for calculating a capacitance value of a flying capacitor according to an embodiment of this application;
FIG. 6 is a diagram of a structure of a direct current/direct current conversion circuit according to an embodiment of this application; and
FIG. 7 is a schematic flowchart of a method for determining a capacitance value of a flying capacitor according to an embodiment of this application.

### DESCRIPTION OF EMBODIMENTS

With reference to the accompanying drawings, the following describes in detail a power converter, a method for determining a capacitance value of a flying capacitor of the power converter, and an energy storage system provided in embodiments of this application. Key terms in embodiments of this application are first described.

Photovoltaic module: The photovoltaic module is also referred to as a photovoltaic panel, and is an apparatus configured to convert solar energy into direct current electric energy by using a photovoltaic effect.

Energy storage battery: The energy storage battery is an electrochemical apparatus that can store electric energy and release electric energy when required.

Power grid: The power grid is an entirety including substations and power transmission and distribution lines of various voltages in a power system, and is also referred to as a public power grid.

DC/DC conversion circuit: The DC/DC conversion circuit is a circuit that converts an input DC into a DC with a different voltage for output, and is configured to implement DC/DC conversion.

DC/AC conversion circuit: The DC/AC conversion circuit is a circuit that converts a DC into an alternating current (alternating current, AC), is configured to implement DC/AC conversion, and is usually referred to as an inverter circuit.

Power conversion system (power conversion system, PCS): The power conversion system is also referred to as a bidirectional energy storage inverter, and is a device that can control charging and discharging of an energy storage battery and perform bidirectional alternating current and direct current conversion, that is, not only can convert a DC into an AC to implement DC/AC conversion, but also can convert an AC into a DC to implement AC/DC conversion.

Boost circuit: The boost circuit is a type of DC/DC conversion circuit, and is configured to boost a direct current from a low voltage to a high voltage. The low voltage and the high voltage herein are relative.

Three-level boost circuit: The three-level boost circuit is a boost circuit that can generate three levels. Common topologies include: a diode clamp type, a flying capacitor type, or a symmetric boost type. In embodiments of this application, a three-level boost circuit of the flying capacitor type is used as an example for description. In the three-level boost circuit of the flying capacitor type, a flying capacitor is generally bridged between a series connection node of two diodes and a series connection node of two switching transistors. In addition, in addition to the flying capacitor, the three-level boost circuit of the flying capacitor type generally further includes an output filter capacitor. In addition, capacitors such as the flying capacitor and the filter capacitor are generally thin film capacitors.

Thin film capacitor: The thin film capacitor is a capacitor that is prepared using a thin film as a dielectric, is generally formed by using a metal layer as an electrode to be evaporated on a plastic film, winding the plastic film into a cylindrical or flat capacitor core, and then performing gold spraying, assembling, resin casting, or oil injection, and has advantages such as a high withstand voltage, low parasitic inductance, and non-polarity.

Sending a PWM driver gating signal and stopping sending a PWM driver gating signal: A power converter generally includes a power conversion circuit, for example, a DC/DC conversion circuit (for example, a three-level boost circuit) or a DC/AC conversion circuit, and a controller. The controller may output a PWM signal to a switching transistor of the power conversion circuit, to control on and off of the switching transistor, so that the power conversion circuit performs power conversion. The PWM signal is also referred to as a PWM wave. Correspondingly, that the controller outputs the PWM signal may mean sending the PWM driver gating signal. Conversely, that the controller stops outputting the PWM wave may mean stopping sending the PWM driver gating signal.

Bus: The bus is a trace connected between the DC/DC conversion circuit and a direct current source. The direct current source generally includes a positive electrode and a negative electrode. Correspondingly, the bus generally includes a positive bus BUS+ connected to the positive electrode and a negative bus BUS- connected to the negative electrode. The direct current source includes, for example, a photovoltaic module and an energy storage battery.

It may be understood that in a device (for example, the DC/DC conversion circuit) in which the thin film capacitor is used, the thin film capacitor generally plays a role of absorbing a high-frequency ripple, suppressing a voltage fluctuation, temporarily storing and releasing energy, and the like, and a health status of the thin film capacitor is highly related to a capacitance value of the thin film capacitor. Due to impact of factors such as an operating environment, operating duration, and an operating condition of the device, the capacitance value of the thin film capacitor is attenuated, and the thin film capacitor continuously ages. In addition, the aging fault spreads and finally affects normal and stable operation of the device. The thin film capacitor herein may be, for example, used as the flying capacitor or the output filter capacitor.

For this technical problem, in some embodiments, for example, the device is the DC/DC conversion circuit. It may be considered that when the DC/DC conversion circuit stops operating and is in an offline state, the capacitance value of the thin film capacitor of the DC/DC conversion circuit is detected through an external detection circuit independent of the DC/DC conversion circuit. However, this detection manner has poor real-time performance, and the external detection circuit required is complex, resulting in high hardware costs. In addition, this detection manner is also applicable to detecting a capacitance value of the output filter capacitor of the DC/DC conversion circuit, but is not applicable to detecting the capacitance value of the flying capacitor.

Based on this, an embodiment of this application provides a manner for detecting a capacitance value of a flying capacitor. In this manner, no additional external detection circuit needs to be disposed, hardware costs are low, and online real-time detection can be implemented. In this way, protection can be implemented in time when the capacitance value of the flying capacitor is low, to prevent spreading of an aging fault of the flying capacitor, and ensure that a device can run normally and stably.

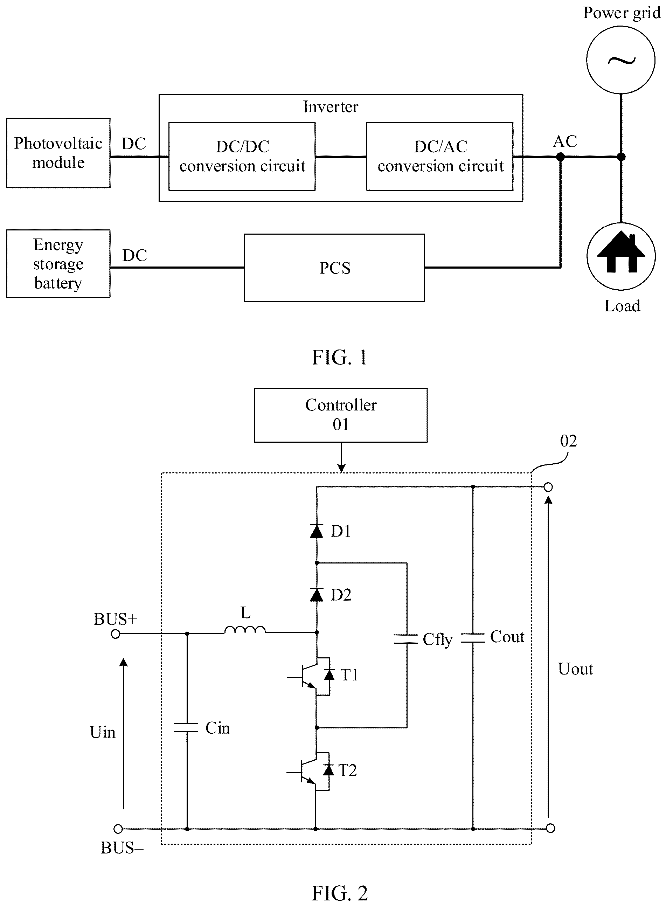

FIG. 1 first shows a diagram of a possible scenario. Refer to FIG. 1. The scenario may be a photovoltaic energy storage (PV energy storage for short) system. The PV energy storage system includes a photovoltaic module, an energy storage battery, an inverter, a PCS, a power grid, and a load (for example, a household load). The inverter includes a DC/DC conversion circuit and a DC/AC conversion circuit. It should be understood that the PCS in the figure may use a circuit architecture the same as that shown in the inverter, and implement, through bidirectional power conversion, that the energy storage battery supplies power to the load, or charge the energy storage battery by using electric energy of the power grid. Optionally, the photovoltaic energy storage system may be used in a commercial and industrial scenario or a power station scenario.

The photovoltaic module and the energy storage battery can provide a DC. The DC/DC conversion circuit can perform voltage conversion on the DC provided by the photovoltaic module. For example, in an embodiment, the DC/DC conversion circuit may be a three-level boost circuit of a flying capacitor type. Correspondingly, the DC/DC conversion circuit can boost the DC provided by the photovoltaic module from a low voltage to a high voltage, to perform boost conversion. The DC/AC conversion circuit can further convert, into an AC, a DC obtained through conversion by the DC/DC conversion circuit, and output the AC to the power grid or the load, to supply power to the power grid or the load. The PCS can convert the DC provided by the energy storage battery into an AC, and output the AC to the power grid or the load, to supply power to the power grid or the load, and can further convert the AC from the power grid into a DC, and output the DC to the energy storage battery, for the energy storage battery to store energy.

FIG. 2 is a diagram of a structure of a power converter according to an embodiment of this application. The power converter may be the inverter in FIG. 1, or may be the PCS in FIG. 1. With reference to FIG. 1 and FIG. 2, it can be learned that the power converter includes a controller 01 and a DC/DC conversion circuit 02.

The DC/DC conversion circuit 02 includes an inductor L, a flying capacitor Cfly, a first diode D1, a second diode D2, a first switching transistor T1, and a second switching transistor T2. The first diode D1, the second diode D2, the first switching transistor T1, and the second switching transistor T2 are sequentially connected in series between a positive bus BUS+ and a negative bus BUS-. One end of the inductor L is configured to connect to an energy storage battery or a photovoltaic module, and the other end of the inductor L is connected to a series connection node of the second diode D2 and the first switching transistor T1. The flying capacitor Cfly is connected in parallel to the second diode D2 and the first switching transistor T1 that are connected in series. In other words, the flying capacitor Cfly is connected between a series connection node of the first diode D1 and the second diode D2 and a series connection node of the first switching transistor T1 and the second switching transistor T2. In addition, the DC/DC conversion circuit 02 further includes an input filter capacitor Cin connected between the positive bus BUS+ and the negative bus BUS-, and an output filter capacitor Cout connected between the positive bus BUS+ and the negative bus BUS-. The DC/DC conversion circuit of this structure is the three-level boost circuit of the flying capacitor type described above. FIG. 2 does not show the energy storage battery or the photovoltaic module, but illustrates that a direct current provided by the energy storage battery or the photovoltaic module is used as an input voltage Uin. On a basis that the first switching transistor T1 and the second switching transistor T2 are periodically turned on and turned off, the DC/DC conversion circuit 02 can convert the input voltage Uin into a required output voltage Uout.

Optionally, the switching transistor described in embodiments of this application may be a switching transistor insulated gate bipolar transistor (insulated gate bipolar transistor, IGBT) or a metal-oxide-semiconductor field-effect transistor (metal-oxide-semiconductor field-effect transistor, MOSFET).

The controller 01 provided in embodiments of this application is configured to:
provide pulse width modulation PWM signals (namely, sending PWM driver gating signals) for the first switching transistor T1 and the second switching transistor T2, to control a capacitance voltage of the flying capacitor Cfly to maintain at half of a bus voltage; and
determine a capacitance value of the flying capacitor Cfly based on an effective value of a current disturbance component of a target frequency on the flying capacitor Cfly and an effective value of a voltage disturbance component of the target frequency on the flying capacitor Cfly.

It may be understood that the bus voltage is a voltage between the positive bus BUS+ and the negative bus BUS-, and is also referred to as a total bus voltage Ubus. Half of the bus voltage (namely, 0.5 Ubus) may be provided for the controller 01 as a reference voltage, so that the controller 01 performs closed-loop control on the capacitance voltage of the flying capacitor Cfly based on the reference voltage. In this way, the capacitance voltage of the flying capacitor Cfly is maintained close to the reference voltage. For example, the controller 01 may compare a magnitude of real-time capacitance voltage of the flying capacitor Cfly with a magnitude of the reference voltage, and flexibly adjust the PWM signal based on a comparison result, to control the capacitance voltage of the flying capacitor Cfly to maintain at the reference voltage. On a basis of controlling the capacitance voltage to maintain at half of the bus voltage, a voltage borne by each switching transistor in the DC/DC conversion circuit 02 may be half of the output voltage, so that voltage stress of each switching transistor can be reduced, and operation reliability of the DC/DC conversion circuit 02 can be improved.

It may be further understood that, for any switching transistor in the first switching transistor T1 and the second switching transistor T2, when a potential of a PWM signal provided by the controller 01 for the switching transistor is a valid potential, the switching transistor is turned on, and when the potential of the PWM signal provided by the controller 01 for the switching transistor is an invalid potential, the switching transistor is turned off. In other words, for any switching transistor, the switching transistor can be controlled to be turned on or turned off by providing a PWM signal for the switching transistor, to control the capacitance voltage of the flying capacitor Cfly. In addition, for an N-type switching transistor, a valid potential is a high potential relative to an invalid potential. For a P-type transistor, a valid potential is a low potential relative to an invalid potential. Each switching transistor shown in FIG. 2 is an N-type switching transistor. Correspondingly, a valid potential described in embodiments of this application is a high potential relative to an invalid potential.

For example, with reference to FIG. 2, when the controller 01 controls the first switching transistor T1 to be turned off and controls the second switching transistor T2 to be turned on, a current can sequentially flow from the positive bus BUS+ through the inductor L, the second diode D2, the flying capacitor Cfly, and the second switching transistor T2. Correspondingly, the flying capacitor Cfly can be charged, so that the capacitance voltage of the flying capacitor Cfly increases. When the controller 01 controls the first switching transistor T1 to be turned on and controls the second switching transistor T2 to be turned off, a current can sequentially flow from the positive bus BUS+ through the inductor L, the first switching transistor T1, the flying capacitor Cfly, and the first switching transistor D1. Correspondingly, the flying capacitor Cfly can be discharged, so that the capacitance voltage of the flying capacitor Cfly decreases. In addition, an inductance current flowing through the inductor L is generally equal to a capacitance current flowing through the flying capacitor Cfly. Certainly, when the controller 01 controls both the first switching transistor T1 and the second switching transistor T2 to be turned off or turned on, because a current does not flow through the flying capacitor Cfly, the capacitance voltage of the flying capacitor Cfly remains unchanged.

Based on this, it can be learned that the controller 01 can control, based on the reference voltage, a duty cycle difference (DeltaDuty) or a pulse difference between a PWM signal provided for the first switching transistor T1 and a PWM signal provided for the second switching transistor T2, to control on and off duration of the first switching transistor T1 and the second switching transistor T2, so as to flexibly control the capacitance voltage of the flying capacitor Cfly. Correspondingly, in the foregoing closed-loop control, the reference voltage may also be an input instruction received by the controller 01, and DeltaDuty may also be an output amount output by the controller 01 according to the input instruction. A duty cycle of the PWM signal is a proportion of duration of a valid potential (for example, a high potential) to duration of an entire switching period in one switching period.

In a scenario in which the capacitance value of the flying capacitor Cfly needs to be detected, in addition to a parameter of half of the bus voltage, the reference voltage further needs to include a disturbance component of the target frequency. For example, the disturbance component of the target frequency may be injected into the input instruction. In this way, not only the capacitance voltage of the flying capacitor Cfly can be controlled to maintain at half of the bus voltage, but also the disturbance component of the target frequency can be brought to both the capacitance voltage of the flying capacitor Cfly and a capacitance current flowing through the flying capacitor Cfly. Optionally, the disturbance component of the target frequency may be a sine alternating current voltage, and is a type of sine alternating current wave. The target frequency may be approximately 100 Hz (Hz). An effective value of the sine alternating current voltage may be from 50 V to 60 V. Certainly, this is merely an example for description.

On this basis, the controller 01 can further determine the capacitance value of the flying capacitor Cfly based on the effective value of the current disturbance component of the target frequency on the flying capacitor Cfly and the effective value of the voltage disturbance component of the target frequency on the flying capacitor Cfly.

The capacitance value is positively correlated with the effective value of the current disturbance component of the target frequency, and the capacitance value is negatively correlated with the effective value of the voltage disturbance component of the target frequency. That is, on a basis that the effective value of the voltage disturbance component of the target frequency is fixed, a larger effective value of the current disturbance component of the target frequency indicates a larger determined capacitance value of the flying capacitor Cfly, and a smaller effective value of the current disturbance component of the target frequency indicates a smaller determined capacitance value of the flying capacitor Cfly. Similarly, on a basis that the effective value of the current disturbance component of the target frequency is fixed, a larger effective value of the voltage disturbance component of the target frequency indicates a smaller determined capacitance value of the flying capacitor Cfly, and a smaller effective value of the voltage disturbance component of the target frequency indicates a larger determined capacitance value of the flying capacitor Cfly. In this way, real-time online detection of the capacitance value of the flying capacitor Cfly is implemented.

In addition, because the capacitance value detection manner is performed by the controller 01 of the power converter, and no additional external detection circuit needs to be disposed, a detection structure is simple, and hardware costs are low. In addition, the capacitance value of the flying capacitor Cfly is detected online, so that a health status of the flying capacitor Cfly can be monitored in real time. Further, when the capacitance value of the flying capacitor Cfly is small and the health status of the flying capacitor Cfly is poor (for example, the flying capacitor Cfly ages), protection can be implemented in time, to prevent fault spreading from caused by continuous aging of the flying capacitor Cfly, and ensure that the DC/DC conversion circuit 02 can operate reliably and stably.

In addition, it may be understood that, in a scenario in which the capacitance value of the flying capacitor Cfly does not need to be detected, the reference voltage may not include the disturbance component of the target frequency. That is, the disturbance component of the target frequency may not be injected into the input instruction. In this way, normal operation of the DC/DC conversion circuit 02 is not affected.

Optionally, in embodiments of this application, the capacitance value C may satisfy: $C = \frac{1}{2 {πf}_{h}} ∗ \frac{{I}_{h , rms}}{{U}_{h , rms}}$ Formula (1). Herein, *fₕ* is the target frequency, *U_{h,rms}* is the effective value of the voltage disturbance component of the target frequency, and *I*_{*h*,*rms*} is the effective value of the current disturbance component of the target frequency.

It may be understood that a subscript h in Formula (1) represents a high frequency, and rms represents a root mean square. That is, in embodiments of this application, the controller 01 may calculate an effective value based on a root mean square. For a sine alternating current wave, an effective value is generally a root mean square of a peak value of the sine alternating current wave.

Optionally, the controller 01 may be configured to:
determine the effective value of the current disturbance component of the target frequency based on an estimated current disturbance component; and
determine the effective value of the voltage disturbance component of the target frequency based on the capacitance voltage.

It may be understood that, because the capacitance current flowing through the flying capacitor Cfly is generally equal to the inductance current flowing through the inductor L, it can be learned that when determining the effective value of the current disturbance component of the target frequency, the controller 01 may first determine the estimated current disturbance component based on the inductance current and the duty cycle difference, and then reliably determine the effective value of the current disturbance component of the target frequency based on the estimated current disturbance component. In addition, the determined estimated current disturbance component is a sine alternating current component that includes a plurality of frequency components and that is generated, under impact of the disturbance component in the reference voltage, in the capacitance current flowing through the flying capacitor Cfly, belongs to a current fluctuation case, and is also referred to as a ripple current of the flying capacitor (flycap ripple, FR). Certainly, in some other embodiments, the controller 01 may further directly determine the effective value of the current disturbance component of the target frequency based on the capacitance current.

The estimated current disturbance component is positively correlated with both the inductance current flowing through the inductor L and the duty cycle difference. That is, on a basis that the duty cycle difference is fixed, a larger inductance current indicates a larger determined estimated current disturbance component, and a smaller inductance current indicates a smaller determined estimated current disturbance component. Similarly, on a basis that the inductance current is fixed, a larger duty cycle difference indicates a larger determined estimated current disturbance component, and a smaller duty cycle difference indicates a smaller determined estimated current disturbance component. In addition, the duty cycle difference is a difference between a duty cycle of the PWM signal provided by the controller 01 for the first switching transistor T1 and a duty cycle of the PWM signal provided by the controller 01 for the second switching transistor T2. That is, DeltaDuty described above.

For example, the estimated current disturbance component I_{FR} may satisfy: I_{FR} = 2*I_{L}*D Formula (2)

Herein, I_{L} is the inductance current, and D is the duty cycle difference, namely, DeltaDuty.

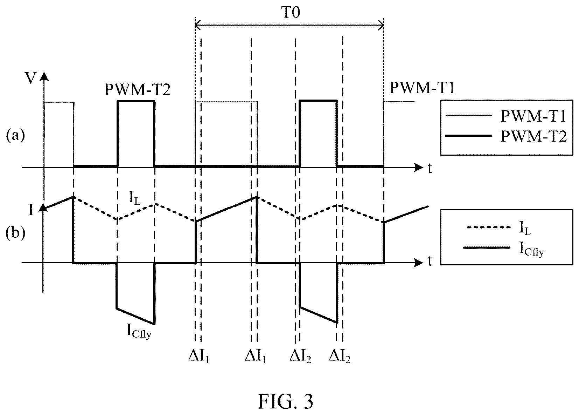

The following describes in detail a manner for determining the estimated current disturbance component with reference Formula formula (2), and signal sequence diagrams shown in FIG. 2 and FIG. 3.

First, FIG. 3 is a sequence diagram (a) of a PWM signal and a sequence diagram (b) of a current changing with time. The PWM signal includes a PWM signal PWM-T1 provided by the controller 01 for the first switching transistor T1 and a PWM signal PWM-T2 provided by the controller 01 for the second switching transistor T2. A current includes an inductance current I_{L} and a capacitance current I_{Cfly}. In addition, horizontal coordinates in both the time sequence diagrams (a) and (b) indicate time, and a unit is second (s). A vertical coordinate in the time sequence diagram (a) indicates a voltage, and a unit is volt (V). A vertical coordinate in the time sequence diagram (b) indicates a current, and a unit is ampere (A). In addition, it can be learned with reference to the foregoing descriptions that, when the first switching transistor T1 or the second switching transistor T2 is turned on, the inductance current I_{L} flowing through the inductor L is generally equal to the capacitance current I_{Cfly} flowing through the flying capacitor Cfly. Correspondingly, it is assumed that DeltaDuty>0. It can be learned with reference to FIG. 3 that, in one switching period T0, duration in which the PWM signal PWM-T1 provided by the controller 01 for the first switching transistor T1 is at a high potential is increased, and duration in which the PWM signal PWM-T2 provided by the controller 01 for the second switching transistor T2 is at a high potential is decreased, that is, the controller 01 controls a duty cycle of the PWM-T1 to increase, and controls a duty cycle of the PWM-T2 to decrease. In this way, turn-on time of the first switching transistor T1 is increased, and turn-on time of the second switching transistor T2 is decreased. In this case, when the PWM-T1 is at the high potential so that the first switching transistor T1 is turned on, a current for charging the flying capacitor Cfly is equivalently increased by I_{L}*DeltaDuty, that is, ΔI1=I_{L}*DeltaDuty. When the PWM-T2 is at the high potential so that the second switching transistor T2 is turned on, a current ΔI2 for discharging the flying capacitor Cfly is equivalently decreased by I_{L}*DeltaDuty, that is, ΔI2=I_{L}*DeltaDuty. It can be learned that, in the switching period T0, the estimated current disturbance component generated in the capacitance current flowing through the flying capacitor Cfly is ΔI=ΔI1-ΔI2=2*I_{L}*DeltaDuty, that is, 2*I_{L}*D. DeltaDuty<0 is similar, but a current direction is opposite. Details are not described again.

Optionally, the controller 01 may be configured to perform band-pass filtering on the estimated current disturbance component to obtain a current component of the target frequency. A passband of the band-pass filtering includes the target frequency, and the effective value of the current disturbance component of the target frequency is an effective value of the current component of the target frequency.

It may be understood that band-pass filtering is a processing manner in which a signal of an included specific frequency is allowed to pass, and a signal of another frequency is attenuated. The passband of the band-pass filtering is a specific frequency that is allowed to pass. Correspondingly, after determining the estimated current disturbance component that includes the plurality of frequency components, the controller 01 may reliably extract the current component of the target frequency from the estimated current disturbance component in the band-pass filtering manner including the target frequency. Both the estimated current disturbance component and the current component are sine alternating current components. Then, the controller 01 may calculate the effective value of the current component of the target frequency. In addition, the effective value of the current disturbance component of the target frequency is the calculated effective value of the current component of the target frequency.

It may be understood that, as described above, for a sine alternating current component, an effective value *I*_{*h*,*rms*} may be calculated based on a root mean square. That is, the effective value of the current component may be a root mean square of the current component. *I*_{*h*,*rms*} may satisfy: ${I}_{h , rms} = \frac{A}{\sqrt{2}}$, where A is a peak value of the current component.

Optionally, the controller 01 may be configured to perform band-pass filtering on the capacitance voltage to obtain a voltage component of the target frequency. A passband of the band-pass filtering includes the target frequency, and the effective value of the voltage disturbance component of the target frequency is an effective value of the voltage component of the target frequency.

It may also be understood that, as described above, because a voltage disturbance component is brought to the capacitance voltage when the capacitance voltage of the flying capacitor Cfly is controlled, the capacitance voltage includes sine alternating current components of a plurality of frequency components. Correspondingly, after determining the capacitance voltage, the controller 01 may also first reliably extract the voltage component of the target frequency from the capacitance voltage in the band-pass filtering manner including the target frequency. Then, the controller 01 may calculate the effective value of the voltage component of the target frequency. In addition, the effective value of the voltage disturbance component of the target frequency is the calculated effective value of the voltage component of the target frequency. A manner for calculating the effective value is the same as that described above. Details are not described herein again.

Certainly, in some other embodiments, the band-pass filtering manner may be replaced with a Fourier transform manner. Determining the current component of the target frequency is used as an example. The Fourier transform manner means: first converting the estimated current disturbance component from time domain to frequency domain through Fourier transform, then determining the target frequency in frequency domain, extracting amplitude and phase information corresponding to the target frequency, and then converting the amplitude and the phase information back to time domain through Fourier inverse transform, to obtain the current component of the target frequency.

Optionally, the inductance current may be an average current value of inductance currents flowing through the inductor L at at least two different moments in each switching period. In other words, in embodiments of this application, the controller 01 may determine the effective value of the current disturbance component of the target frequency based on the average current value of the inductance currents, instead of determining the effective value of the current disturbance component of the target frequency based on an instantaneous current value of the inductance current at a moment.

For example, the controller 01 may detect inductance currents that flow through the inductor L at at least two different moments in each switching period, and then calculate an average current value of the inductance currents that flow through the inductor L at the at least two different moments.

It may be understood that, because the average current value can better represent a current change trend compared with the instantaneous current, the controller 01 can reliably determine an accurate effective value of the current disturbance component.

Optionally, in some embodiments, the controller 01 may detect inductance currents that flow through the inductor L at at two different moments and that near an inductance current with a maximum value, and calculate an average current value of the inductance currents that flow through the inductor L at the two different moments. In other words, the controller 01 may determine the effective value of the current disturbance component of the target frequency based on the average current value of the inductance currents that flow through the inductor L at the at two different moments and that near the inductance current with the maximum value. In this way, the average current value that can better reflect the current change trend can be quickly and reliably obtained by using a small amount of detection and calculation.

Optionally, the controller 01 may be further configured to:
if the capacitance value of the flying capacitor Cfly is less than a capacitance value threshold, perform at least one of the following operations:
decreasing rated power of the DC/DC conversion circuit 02;
controlling the DC/DC conversion circuit 02 to stop operating; and
sending an alarm signal.

The capacitance value threshold may be less than or equal to a nominal capacitance value of the flying capacitor Cfly. Optionally, the nominal capacitance value may be a capacitance value that is marked on the flying capacitor Cfly and that is measured under a standard condition (for example, a specific temperature), or may be a capacitance value that is measured in an early use process after the flying capacitor Cfly is delivered from a factory, and represents that the flying capacitor Cfly is in a good health state. A unit of the nominal capacitance value is generally farad (F). In addition, the capacitance value threshold may be a target percentage of the nominal capacitance value of the flying capacitor Cfly. In addition, the capacitance value threshold may be pre-stored in the controller 01 or may be flexibly adjusted. For example, the target percentage may be, for example, 95%. This may also be understood as that the controller 01 determines, when detecting that the capacitance value of the flying capacitor Cfly is decreased by approximately 5% of the nominal capacitance value, that the capacitance value of the flying capacitor Cfly is less than the capacitance value threshold.

In other words, in embodiments of this application, after determining the capacitance value of the flying capacitor Cfly, the controller 01 may further detect whether the capacitance value of the flying capacitor Cfly is less than the capacitance value threshold, or in other words, whether the capacitance value of the flying capacitor Cfly is less than the target percentage of the nominal capacitance value, and may perform one or more of the foregoing operations when the capacitance value of the flying capacitor Cfly is less than the capacitance value threshold, to prevent the flying capacitor Cfly from affecting stable operation of the DC/DC conversion circuit 02 due to an abnormality, and implement timely and reliable protection for the DC/DC conversion circuit 02, for example, prevent fault spreading caused by continuous aging of the flying capacitor Cfly.

Decreasing the rated power of the DC/DC conversion circuit 02 may also be referred to as a derating operation. Controlling the DC/DC conversion circuit 02 to stop operating or sending the alarm signal may also be referred to as a protection operation. In other words, the controller 01 may prevent fault spreading by performing the derating operation and/or the protection operation.

In addition, for example, the controller 01 may directly or indirectly decrease the rated power of the DC/DC conversion circuit 02 by reducing output power of the DC/DC conversion circuit 02 or reducing a switching frequency of the switching transistor in the DC/DC conversion circuit 02. The controller 01 may make, by stopping sending the PWM driver gating signal, the DC/DC conversion circuit 02 stop operating. The alarm signal may include a sound signal, a light signal, and/or the like. In addition, the alarm signal is sent to notify maintenance personnel that the DC/DC conversion circuit 02 is abnormal, so that the maintenance personnel pay attention to and handle the abnormality.

Optionally, as described above, the flying capacitor Cfly may be a thin film capacitor. The thin film capacitor has advantages such as a high ripple current bearing capability, high voltage resistance, and a long service life. Certainly, in some other embodiments, the flying capacitor Cfly may alternatively be a ceramic capacitor, an electrolytic capacitor, or the like.

The ceramic capacitor is a capacitor made by alternately stacking and sintering two or more ceramic dielectric layers and metal electrode layers. The electrolytic capacitor is a capacitor made by using an aluminum foil or a tantalum foil as an anode, immersing the anode in an electrolyte, and then covering the anode with a cathode metal foil (for example, aluminum foil or carbon material).

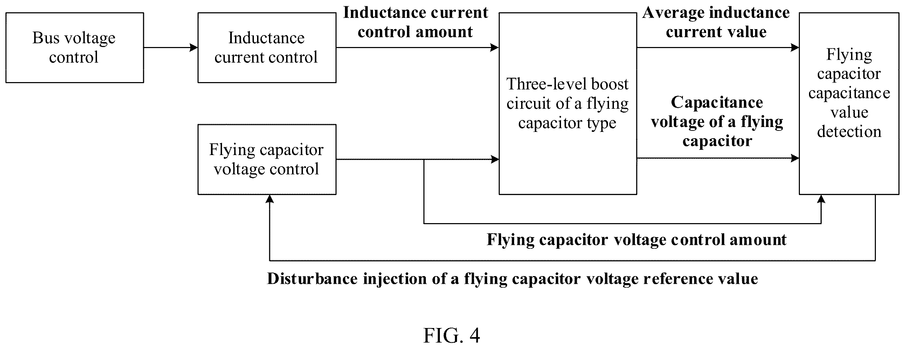

With reference to the foregoing descriptions, for example, the DC/DC conversion circuit is a three-level boost circuit of a flying capacitor type. FIG. 4 is a block diagram of a control loop of a power converter. Refer to FIG. 4. It can be learned that the control loop may include a bus voltage control module, an inductance current control module, a flying capacitor voltage control module, and a flying capacitor capacitance value detection module that are disposed around the three-level boost circuit of the flying capacitor type, and these modules are all modules of the controller 01.

The bus voltage control module may output a control signal by comparing an actual value of a bus voltage with a reference value of the bus voltage, so that the inductance current control module outputs an inductance current control amount, to control an inductance current in the flying capacitor type three-level boost circuit. The flying capacitor voltage control module may output a flying capacitor voltage control amount based on the input instruction described above, to control a capacitance voltage of the flying capacitor. In addition, the input instruction may include, for example, the direct current component (for example, half of the bus voltage) and the disturbance component of the target frequency (for example, the sine alternating current voltage), to bring the disturbance component of the target frequency to the capacitance voltage and the capacitance current of the flying capacitor Cfly, so as to facilitate subsequent capacitance value calculation. In addition, both the inductance current control amount and the flying capacitor voltage control amount may be PWM signals. The PWM signals can be used to control on and off of each switching transistor in the three-level boost circuit of the flying capacitor type, to control the inductance current and the capacitance voltage.

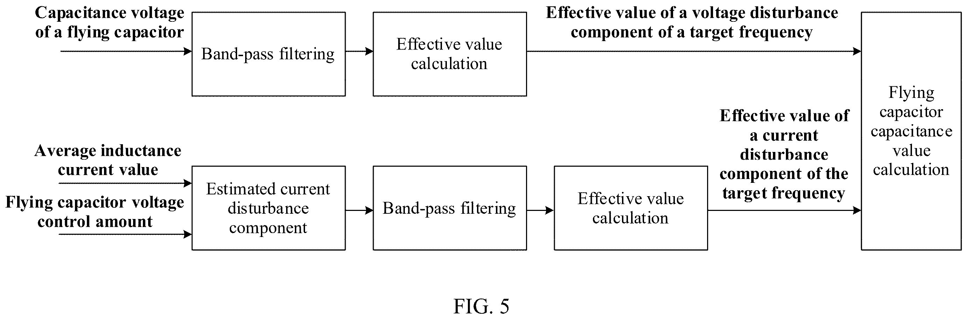

On this basis, with reference to FIG. 4 and a block diagram of capacitance value calculation shown in FIG. 5, it can be learned that the flying capacitor capacitance value detection module may first obtain the capacitance voltage, the inductance current, and the flying capacitor voltage control amount of the flying capacitor, and then detect the capacitance value by using the following steps.
(1) Inject the disturbance component of the target frequency into the input instruction, to bring the disturbance component of the target frequency into the capacitance voltage and the capacitance current of the flying capacitor Cfly. That is, the flying capacitor capacitance value detection module may inject the disturbance component of the target frequency into the input instruction that originally has the direct current component, which corresponds to disturbance injection of a flying capacitor voltage reference value in FIG. 4.
(2) Determine, based on the inductance current flowing through the inductor and the flying capacitor voltage control amount, the estimated current disturbance component that appears in the capacitance current, then extract the current component of the target frequency from the estimated current disturbance component through band-pass filtering, and extract the voltage component of the target frequency from the capacitance voltage through band-pass filtering. The inductance current may be, for example, the average current value of the inductance currents. The flying capacitor voltage control amount may be the duty cycle difference DeltaDuty between the PWM signals described above.
(3) Calculate the effective value of the current component of the target frequency, and calculate the effective value of the voltage component of the target frequency. The effective value of the current component of the target frequency is the required effective value of the current disturbance component of the target frequency. The effective value of the voltage component of the target frequency is the required effective value of the voltage disturbance component of the target frequency. Then, the effective value of the current disturbance component of the target frequency and the effective value of the voltage disturbance component of the target frequency are substituted into the foregoing Formula (1) to calculate the capacitance value of the flying capacitor Cfly, and calculation of the capacitance value of the flying capacitor is completed.

In addition, as described above, after the capacitance value of the flying capacitor Cfly is calculated, the flying capacitor capacitance value detection module may further perform the following step.

(4) Perform derating and protection when detecting that the capacitance value of the flying capacitor Cfly is less than the target percentage of the nominal capacitance value, to implement timely and reliable protection for the three-level boost circuit of the flying capacitor type. Certainly, the derating action and the protection action may alternatively be performed by another module. This is not limited herein.

Optionally, in embodiments of this application, the controller 01 may be, for example, a micro controller unit (micro controller unit, MCU). In addition, a current sampling circuit may be disposed for the controller 01 to obtain the inductance current, and a voltage sampling circuit may be disposed for the controller 01 to obtain the capacitance voltage. The current sampling circuit may include, for example, a sampling resistor. The voltage sampling circuit may include, for example, a voltage divider circuit and an amplifier.

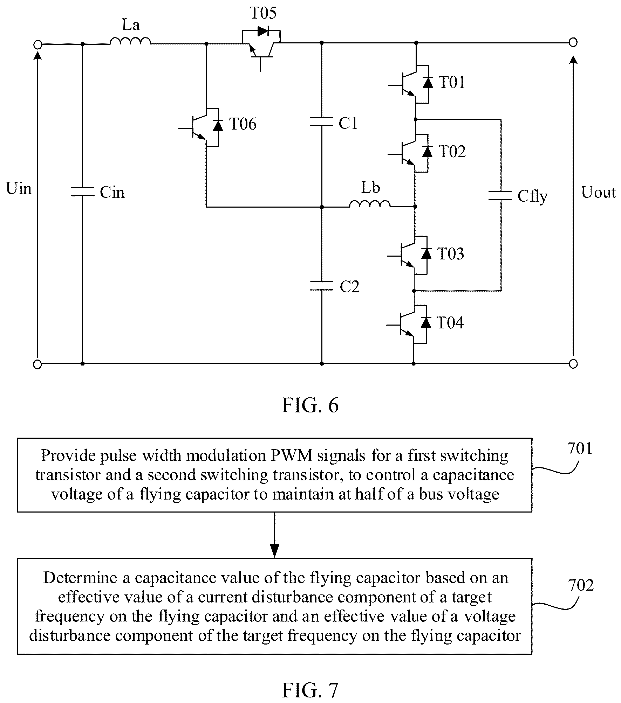

It may be understood that the capacitance value detection manner provided in embodiments of this application is not only applicable to the DC/DC conversion circuit 02 shown in FIG. 2, namely, the three-level boost circuit of the flying capacitor type, but also applicable to various DC/DC conversion circuits of other structures, for example, an isolated DC/DC conversion circuit of a structure shown in FIG. 6.

In conclusion, an embodiment of this application provides a power converter. The power converter includes a controller and a direct current/direct current conversion circuit. In the direct current/direct current conversion circuit, a capacitance voltage of a flying capacitor has a voltage disturbance component of a target frequency, and a capacitance current flowing through the flying capacitor has a current disturbance component of the target frequency. Therefore, the controller can reliably calculate a capacitance value of the flying capacitor based on an effective value of the current disturbance component of the target frequency and an effective value of the voltage disturbance component of the target frequency, to implement real-time online detection of the capacitance value of the flying capacitor.

An embodiment of this application further provides a method for determining a capacitance value of a flying capacitor of a power converter. As shown in FIG. 2, the power converter includes the controller 01 and the DC/DC conversion circuit 02. The DC/DC conversion circuit 02 includes the flying capacitor Cfly, the inductor L, the first diode D1, the second diode D2, the first switching transistor T1, and the second switching transistor T2. The first diode D1, the second diode D2, the first switching transistor T1, and the second switching transistor T2 are sequentially connected in series between the positive bus BUS+ and the negative bus BUS-. One end of the inductor L is configured to connect to the energy storage battery or the photovoltaic module, and the other end of the inductor L is connected to the series connection node of the second diode D2 and the first switching transistor T1. The flying capacitor Cfly is connected in parallel to the second diode D2 and the first switching transistor T1 that are connected in series. The method may be performed by the controller 01. As shown in FIG. 7, the method includes the following steps.

Step 701: Provide pulse width modulation PWM signals for the first switching transistor and the second switching transistor, to control a capacitance voltage of the flying capacitor to maintain at half of a bus voltage.

Based on the foregoing descriptions, the controller 01 can perform closed-loop control on the capacitance voltage of the flying capacitor Cfly based on a reference voltage that includes half of the bus voltage, to control the capacitance voltage of the flying capacitor Cfly to maintain close to the reference voltage. In addition, in a scenario in which a capacitance value of the flying capacitor Cfly needs to be detected, in addition to a parameter of half of the bus voltage, the reference voltage further needs to include a disturbance component of a target frequency. In this way, not only the capacitance voltage of the flying capacitor Cfly can be controlled to maintain at half of the bus voltage, but also the disturbance component of the target frequency can be brought to both the capacitance voltage of the flying capacitor Cfly and a capacitance current flowing through the flying capacitor Cfly, to facilitate subsequent calculation of the capacitance value.

Step 702: Determine the capacitance value of the flying capacitor based on an effective value of a current disturbance component of the target frequency on the flying capacitor and an effective value of a voltage disturbance component of the target frequency on the flying capacitor.

On a basis of obtaining the effective value of the current disturbance component of the target frequency and the effective value of the voltage disturbance component of the target frequency, the controller 01 can determine the capacitance value of the flying capacitor based on the effective value of the current disturbance component of the target frequency and the effective value of the voltage disturbance component of the target frequency, to implement reliable detection of the capacitance value of the flying capacitor. In addition, the capacitance value is positively correlated with the effective value of the current disturbance component of the target frequency, and the capacitance value is negatively correlated with the effective value of the voltage disturbance component of the target frequency.

It may be understood that, because the method for determining a capacitance value of a flying capacitor has a basically same implementation and technical effect as the power converter, for brevity, the implementation and technical effect of the method for determining a capacitance value of a flying capacitor are not described herein again.

An embodiment of this application further provides an energy storage system. With reference to FIG. 1, the energy storage system includes the energy storage battery and the power converter described above.

The DC/DC conversion circuit of the power converter is connected to the energy storage battery, and is configured to perform voltage conversion on a direct current provided by the energy storage battery.

It may be understood that, because the energy storage system and the power converter have basically the same technical effect, for brevity, the technical effect of the energy storage system is not described herein again.

In embodiments of this application, the terms "first", "second", and "third" are merely used for description, but cannot be understood as an indication or implication of relative importance. The term "at least one" means one or more, and "a plurality of" means two or more.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification usually indicates an "or" relationship between the associated objects.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A power converter, wherein the power converter comprises a controller and a direct current/direct current conversion circuit, the direct current/direct current conversion circuit comprises an inductor, a flying capacitor, a first diode, a second diode, a first switching transistor, and a second switching transistor, the first diode, the second diode, the first switching transistor, and the second switching transistor are sequentially connected in series between a positive bus and a negative bus, one end of the inductor is configured to connect to an energy storage battery or a photovoltaic module, the other end of the inductor is connected to a series connection node of the second diode and the first switching transistor, and the flying capacitor is connected in parallel to the second diode and the first switching transistor that are connected in series; and the controller is configured to:
provide pulse width modulation, PWM, signals for the first switching transistor and the second switching transistor, to control a capacitance voltage of the flying capacitor to maintain at half of a bus voltage; and
determine a capacitance value of the flying capacitor based on an effective value of a current disturbance component of a target frequency on the flying capacitor and an effective value of a voltage disturbance component of the target frequency on the flying capacitor, wherein the capacitance value is positively correlated with the effective value of the current disturbance component of the target frequency, and the capacitance value is negatively correlated with the effective value of the voltage disturbance component of the target frequency.

2. The power converter according to claim 1, wherein the capacitance value C satisfies: $C = \frac{1}{2 {πf}_{h}} ∗ \frac{{I}_{h , rms}}{{U}_{h , rms}}$, wherein
*fₕ* is the target frequency, *U_{h,rms}* is the effective value of the voltage disturbance component of the target frequency, and *I_{h,rms}* is the effective value of the current disturbance component of the target frequency.

3. The power converter according to claim 1 or 2, wherein the controller is configured to:
determine the effective value of the current disturbance component of the target frequency based on an estimated current disturbance component, wherein the estimated current disturbance component is positively correlated with both an inductance current flowing through the inductor and a duty cycle difference, and the duty cycle difference is a difference between a duty cycle of the PWM signal provided by the controller for the first switching transistor and a duty cycle of the PWM signal provided for the second switching transistor; and
determine the effective value of the voltage disturbance component of the target frequency based on the capacitance voltage.

4. The power converter according to claim 3, wherein the controller is configured to:
perform band-pass filtering on the estimated current disturbance component to obtain a current component of the target frequency, wherein a passband of the band-pass filtering comprises the target frequency, and the effective value of the current disturbance component of the target frequency is an effective value of the current component of the target frequency.

5. The power converter according to claim 3 or 4, wherein the estimated current disturbance component I_{FR} satisfies: I_{FR} = 2*I_{L}*D, wherein
I_{L} is the inductance current, and D is the duty cycle difference.

6. The power converter according to any one of claims 3 to 5, wherein the controller is configured to:
perform band-pass filtering on the capacitance voltage to obtain a voltage component of the target frequency, wherein a passband of the band-pass filtering comprises the target frequency, and the effective value of the voltage disturbance component of the target frequency is an effective value of the voltage component of the target frequency.

7. The power converter according to any one of claims 3 to 6, wherein the inductance current is an average current value of inductance currents flowing through the inductor at at least two different moments in each switching period.

8. The power converter according to any one of claims 1 to 7, wherein the controller is further configured to:
if the capacitance value of the flying capacitor is less than a capacitance value threshold, perform at least one of the following operations:
decreasing rated power of the direct current/direct current conversion circuit;
controlling the direct current/direct current conversion circuit to stop operating; and
sending an alarm signal, wherein
the capacitance value threshold is less than or equal to a nominal capacitance value of the flying capacitor.

9. A method for determining a capacitance value of a flying capacitor of a power converter, wherein the power converter comprises a controller and a direct current/direct current conversion circuit, the direct current/direct current conversion circuit comprises the flying capacitor, an inductor, a first diode, a second diode, a first switching transistor, and a second switching transistor, the first diode, the second diode, the first switching transistor, and the second switching transistor are sequentially connected in series between a positive bus and a negative bus, one end of the inductor is configured to connect to an energy storage battery or a photovoltaic module, the other end of the inductor is connected to a series connection node of the second diode and the first switching transistor, and the flying capacitor is connected in parallel to the second diode and the first switching transistor that are connected in series; and the method comprises:
providing pulse width modulation, PWM, signals for the first switching transistor and the second switching transistor, to control a capacitance voltage of the flying capacitor to maintain at half of a bus voltage; and
determining a capacitance value of the flying capacitor based on an effective value of a current disturbance component of a target frequency on the flying capacitor and an effective value of a voltage disturbance component of the target frequency on the flying capacitor, wherein the capacitance value is positively correlated with the effective value of the current disturbance component of the target frequency, and the capacitance value is negatively correlated with the effective value of the voltage disturbance component of the target frequency.

10. An energy storage system, wherein the energy storage system comprises an energy storage battery and the power converter according to any one of claims 1 to 8; and
the direct current/direct current conversion circuit of the power converter is connected to the energy storage battery, and the direct current/direct current conversion circuit is configured to perform voltage conversion on a direct current provided by the energy storage battery.
